# EUROPEAN PATENT APPLICATION

(11) **EP 1 930 776 A1**
(43) Date of publication of application: **11.06.2008**
(21) Application number: 06797710.8
(22) Date of filing: 08.09.2006
(51) Int. Cl.: G03F 7/36, B29C 33/38, B29L 11/00, B82B 3/00, G02B 5/18, G03F 7/075, G03F 7/20

(54) **PROCESS FOR PRODUCING 3-DIMENSIONAL MOLD, PROCESS FOR PRODUCING MICROFABRICATION PRODUCT, PROCESS FOR PRODUCING MICROPATTERN MOLDING, 3-DIMENSIONAL MOLD, MICROFABRICATION PRODUCT, MICROPATTERN MOLDING AND OPTICAL DEVICE**

(30) Priority: 09.09.2005 JP 2005262519; 27.02.2006 JP 2006051070
(71) Applicant: Tokyo University of Science Educational Foundation Administrative Organization, Tokyo, 162-8601 (JP)
(72) Inventor: TANIGUCHI, Jun, Shinjuku-ku, Tokyo, 162-8601 (JP)
(74) Representative: Goddar, Heinz J.
(86) International application number: PCT/JP2006/317856
(87) International publication number: WO 2007/029810

(57) **Abstract**

A process for producing a 3-dimensional mold, including irradiating a resist layer of a processing object having the resist layer made of an organopolysiloxane on a substrate with an electron beam, and developing, by thermal desorption treatment, the resist layer after the irradiation with an electron beam to form protrusions and depressions in the resist layer; a process for producing a microfabrication product by using the 3-dimensional mold; a process for producing a micropattern molding by using the 3-dimensional mold or the microfabrication product; and a 3-dimensional mold, a microfabrication product and a micropattern molding which are finely formed by these production processes, as well as an optical device.

## Description

### Technical Field

The present invention relates to a process for producing a 3-dimensional mold which may be finely formed, a process for producing a microfabrication product by using the 3-dimensional mold, a process for producing a micropattern molding by using the 3-dimensional mold or the microfabrication product, a 3-dimensional mold, a microfabrication product and a micropattern molding obtained by these production processes, and an optical device.

### Background Art

The design rule of acceleratingly highly integrated ULSI is estimated to be on the order of nanometers in the near future, and further downsizing is desired.

Under such circumstance, the inventor has revealed that acceleration voltage and processed depth formed have a nearly proportional relationship by changing acceleration voltage, particularly by changing apparent acceleration voltage by changing the voltage at the side of a sample stand, and have proposed a processing and manufacturing method for a resist and a substrate exhibiting an excellent analog property (see, for example, Patent Document 1).

For allowing a prepared element to fulfill an objective function, a certain pattern height is necessary. For example, a resist film when used as an etching mask will hardly attain sufficient processed depth unless the resist film has a certain thickness, and thus its aspect ratio should be made high in order to attain a finer pattern.

However, when a liquid is used in a step of developing or rinsing a fine pattern having a high aspect ratio, the adhesion and collapse of the pattern, etc. may be generated by the capillary phenomenon of the liquid even if a resist showing an excellent analog property is used. In addition, a waste developing solution requires a harm-eliminating process and is harmful to the environment.

For preventing a pattern from collapsing, a method of using a supercritical fluid in development or rinsing has been developed (see, for example, Non-Patent Document 1). The supercritical fluid is a fluid having a state capable of conversion, under supercritical fluid conditions, into gas continuously without forming an intermediate between liquid and gas. In a development method of using a supercritical fluid, problems such as collapse of a pattern are hardly generated because of a reduction in the surface tension of the liquid to which a pattern is exposed. Formation of L&S (line & space) of 150 nm in height and 20 nm in width has been made successful by this method (see, for example, Non-Patent Documents 1 and 2).
When a supercritical fluid is used, however, a special apparatus such as a chamber capable of pressurization is necessary.

As a method of forming a fine line not requiring a special apparatus, there is a method of forming a fine pattern by thermal desorption of an oxide film on silicon. This method involves irradiating an oxide film on silicon with an electron beam and burning it at high temperature, thus eliminating the electron beam-irradiated portion through thermal desorption, thereby succeeding in forming a fine pattern (see, for example, Non-Patent Document 3 and Patent Document 2).
In this method, a light-exposed sample is developed by burning without using a liquid, and therefore, a pattern may be formed without the influence of the surface tension of a liquid that induces pattern collapse and without using a special apparatus.
However, this method may be applied to only a silicon oxide film formed by oxidizing the surface of silicon and is thus disadvantageous in that the area where a pattern may be formed is limited to the surface of silicon, and processed depth is limited to the thickness of the oxide film, that is, to the degree of few nanometers or so.

In consideration of the process for manufacturing a 3-dimensional mold, use of a resist pattern as an etching mask requires subsequent dry etching of a metallic layer disposed between a substrate and a resist layer, dry etching of the substrate, and further removal of the resist layer, thus inevitably increasing the number of steps. Accordingly, there has also been a strong demand for simplification of the process for manufacturing a 3-dimensional mold. Patent Document 1: International Publication No. 2004/027843 A1
Patent Document 2: Japanese Patent No. 2,922,149
Non-Patent Document 1: H. Namatsu, K. Yamazaki and K. Kurihara, J. Vac. Sci. Technol. B 18 780 (2000)
Non-Patent Document 2: H. Namatsu, J. Vac. Sci. Technol. B 18 3308 (2000)
Non-Patent Document 3: H. Watanabe and M. Ichikawa, Surf. Sci. 408 (1998) 95

### Disclosure of the Invention

### Problems to be solved by the Invention

A first problem of the present invention is to provide a process for producing a 3-dimensional mold that may form a fine shape, particularly a fine line less liable to pattern adhesion and collapse.
A second problem of the invention is to provide a process for producing a microfabrication product by using the 3-dimensional mold or a process for producing a micropattern molding by using the 3-dimensional mold or the microfabrication product.
A third problem of the invention is to provide a 3-dimensional mold, a microfabrication product and a micropattern molding which are obtained by these production processes, as well as an optical device.

### Means for Solving Problems

To solve these problems, the inventor made extensive study, and as a result, they solved the problems by the following inventions:

<1> A process for producing a 3-dimensional mold, including:
irradiating a resist layer of a processing object having the resist layer made of an organopolysiloxane on a substrate with an electron beam, and
developing the resist layer after the irradiation with an electron beam to form protrusions and depressions in the resist layer,
wherein the development is development by thermal desorption treatment.

<2> The process for producing a 3-dimensional mold according to claim 1, wherein the organic group in the organopolysiloxane is a methyl group or a phenyl group.

<3> The process for producing a 3-dimensional mold according to claim 1, wherein the organic group in the organopolysiloxane is a methyl group.

<4> The process for producing a 3-dimensional mold according to any of the above-mentioned <1> to <3>, wherein the heating temperature in the thermal desorption treatment is not more than the glass transition temperature of the organopolysiloxane.

<5> The process for producing a 3-dimensional mold according to claim 4, wherein the heating temperature in the thermal desorption treatment is 600°C or less when the organic group in the organopolysiloxane is a methyl group and simultaneously the content of the organic group in the organopolysiloxane is from 5 to 25% by mass.

<6> A 3-dimensional mold of 100 nm or less in line width produced by the process according to any of the above-mentioned <1> to <5>.

<7> A process for producing a microfabrication product including a substrate having protrusions and depressions, the process including irradiating with an ion beam a resist layer of a 3-dimensional mold produced by the process for producing a 3-dimensional mold, in which a resist layer having protrusions and depressions is provided on a substrate, according to any of the above-mentioned <1> to <5>, whereby protrusions and depressions are formed on the substrate.

<8> A microfabrication product having a processed portion of 100 nm or less in line width produced by the process according to the above-mentioned <7>.

The microfabrication product according to the above-mentioned <8>, which comprises diamond, silicon, glass, sapphire, glassy carbon, or silicon carbide.

<10> A process for producing a micropattern molding, including:
transferring a pattern through molding to a resin by pressing the resin against a 3-dimensional mold as a mold produced by the process according to any of the above-mentioned <1> to <5>, and
releasing the pressed resin from the 3-dimensional mold.

<11> A process for producing a micropattern molding, including:
transferring a pattern through molding to a resin by pressing the resin against a microfabrication product produced by the process according to the above-mentioned <7>, which is used as a mold, and
releasing the pressed resin from the microfabrication product.

<12> A micropattern molding having a processed portion of 100 nm or less in line width produced by the process according to the above-mentioned <10> or <11>.

<13> An optical device having a 3-dimensional mold produced by the process of any of the above-mentioned <1> to <5>.

<14> An optical device having a microfabrication product produced by the process of the above-mentioned <7>.

<15> An optical device having a micropattern molding produced by the process of the above-mentioned <10> or <11>.

### Effect of the Invention

According to the present invention, there may be provided a process for producing a 3-dimensional mold that may form a fine shape, particularly a fine line less liable to pattern adhesion and collapse, a process for producing a microfabrication product by using the 3-dimensional mold, a process for producing a micropattern molding by using the 3-dimensional mold or the microfabrication product, and a 3-dimensional mold, a microfabrication product and a micropattern molding which are obtained by these production processes, as well as an optical device.

### Brief Description of the Drawings

Fig. 1 is a schematic view showing the process for producing a 3-dimensional mold and a microfabrication product.
Fig. 2 is a graph showing the relationship between the heating temperature in thermal desorption treatment and the result of TDS analysis or film reduction, where thermal desorption treatment was carried out without irradiation with an electron beam.
Fig. 3 (A) is a graph showing the relationship between the heating temperature in thermal desorption treatment and the result of TDS analysis or film reduction, where irradiation with an electron beam and thermal desorption treatment were carried out, and Fig. 3 (B) is a view explaining the definition of film reduction, processed depth, and film reduction in an irradiated portion in Fig. 3 (A).
Fig. 4 is a schematic view showing the process for producing a micropattern molding.
Fig. 5 is a view showing the result of a step height measurement, which shows the processed depth of a 3-dimensional mold obtained of Example 1 in the present invention.
Fig. 6 is a view showing the result of a step height measurement, which shows the state of a hole formed on a resist surface without irradiation with an electron beam in Example 1 in the invention.
Fig. 7 is a graph showing the relationship between the temperature in thermal desorption treatment and the processed depth in a 3-dimensional mold obtained by changing the acceleration voltage of an electron beam and the dose amount in Example 2 of the invention.
Fig. 8 is an AFM image of the 3-dimensional mold obtained in Example 3 of the invention.
Fig. 9 is a graph showing the relationship between the temperature in thermal desorption treatment and the processed depth in a 3-dimensional mold obtained by changing the acceleration voltage of an electron beam and the dose amount in Example 8 of the invention.
Fig. 10 is a graph showing the relationship between the temperature in thermal desorption treatment and the processed depth in a 3-dimensional mold obtained by changing the acceleration voltage of an electron beam and the dose amount in Example 9 of the invention.
Fig. 11 is a graph showing the relationship between the processed depth of a 3-dimensional mold and the heating temperature in thermal desorption in Example 10 of the invention.
Fig. 12 is a graph showing the relationship between the processed depth of a 3-dimensional mold and the dose amount in Example 11 of the invention.
Fig. 13 is a graph showing the relationship between the processed depth formed by light exposure only without thermal desorption treatment and the dose amount.
Fig. 14 is a graph showing the relationship between the processed depth formed by light exposure only and the processed depth formed by performing thermal desorption treatment.
Fig. 15 is a view showing the profile of a line where a line-shaped pattern obtained in Example 12 in the invention and subjected to image processing with AFM is observed from the above.
Fig. 16 is a view showing the profile of a line where a line-shaped pattern obtained in Example 12 of the invention and subjected to image processing with AFM is obliquely observed.
Fig. 17 is a graph showing the relationship between the line width of the 3-dimensional molds formed in Examples 12 and 13 and the dose amount.
Fig. 18 is a graph showing the relationship between the line width of the 3-dimensional mold formed in Example 14 and the dose amount.

### Best Mode Carrying Out the Invention

### 1. Process for producing a 3-dimensional mold

The process for producing a 3-dimensional mold provided on a substrate with a resist layer having protrusions and depressions according to the invention is a process for producing a 3-dimensional mold including irradiating a resist layer of a processing object having the resist layer on a substrate with an electron beam, and developing the resist layer after the irradiation with an electron beam to form protrusions and depressions in the resist layer, wherein the development is development by thermal desorption treatment.

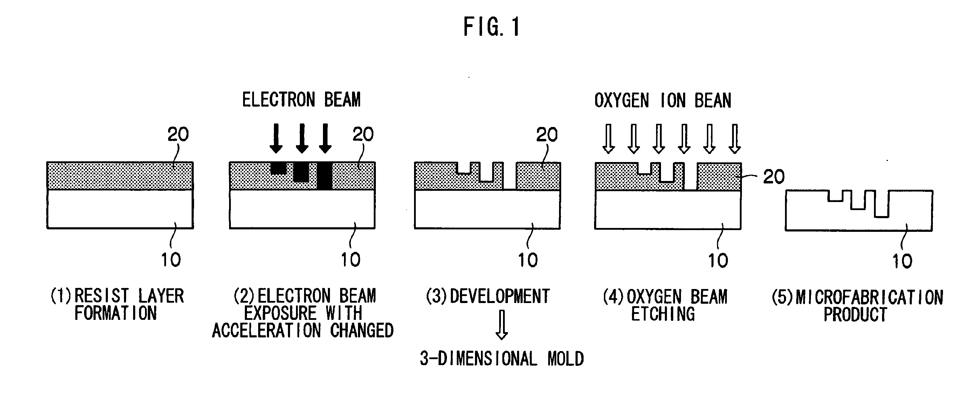

The process for producing the 3-dimensional mold is shown in Fig. 1(1) to Fig. 1 (3). In Fig. 1, there are a step of forming a resist layer, an irradiation step and a development step.

### 1-1. Production of a processing object having a resist layer on a substrate

The processing object having a resist layer on a substrate includes an object using a resist layer prepared separately and dependently before the step of irradiation with an electron beam and an object using a resist layer prepared in one step of forming a resist layer among a series of serially conducted steps including a step of forming a resist layer, a step of irradiation with an electron beam and a step of development.

Hereinafter, one step of forming a resist layer among a series of steps will be described.
First, a resist layer is formed on a substrate 10. As the resist used in the present invention, an organopolysiloxane is used. When the polysiloxane is used as a resist, a resist layer having protrusions and depressions formed thereon can, without releasing the resist, be used directly as a 3-dimensional mold for use in molding a micropattern molding. Accordingly, the operation of dry etching and the operation of releasing a resist may be unnecessary, and the manufacturing operation may be simplified.
When an organopolysiloxane having an organic group is used, a bond between a silicon atom and a carbon atom is made easily cleavable in an irradiated portion, so upon heating in the subsequent development step, the bond between a silicon atom and a carbon atom is cleaved to eliminate carbon easily, thus simplifying the processing and making a microscopic pattern easily formable. In addition, the temperature in thermal desorption treatment may be made lower.

The organic group may include a methyl group and a phenyl group, and from the viewpoint of easy availability, a polysiloxane having a methyl group is preferable.
The organopolysiloxane having a methyl group includes, for example, methyl silsesquioxane, methyl siloxane, ladder methyl silsesquioxane, and methyl silicone.

The content of an organic group in the organopolysiloxane is preferably from 5 to 25% by mass, and more preferably from 10 to 15% by mass. When the content is less than 5% by mass, processable depth by thermal desorption treatment may be reduced, while when the content is more than 25% by mass, a resist pattern formed may be poor in strength.

The method of forming a resist layer may be any method, and a dipping method, a spin coating method, a vapor deposition method, a spraying method or the like may be applied. However, a spin coating method is preferable because the thickness of the coating film is easily controlled. An coating solvent such as acetone, methanol, ethanol, toluene, isopropyl alcohol, xylene, methyl isobutyl ketone, tetrahydrofuran, and butanol may be applied, more preferably isopropyl alcohol, acetone, ethanol, or butanol is used.

If the resist layer is formed using a solvent, a fixed amount of the solvent is then removed by baking the coated resist. The preferred range of the baking temperature differs depending on the type of the resist and the solvent. However, the baking temperature is an important factor in manufacturing a 3-dimensional mold with high precision.
Specifically, if the resist material is for example an organopolysiloxane having a methyl group and the coating solvent is a mixed solvent of isopropyl alcohol, acetone, ethanol and butanol, then the baking temperature is preferably 350°C or more, more preferably from 350 to 550°C, and further preferably from 400 to 450°C. The baking time is preferably 10 to 300 minutes, more preferably 30 to 120 minutes.

The film thickness of the formed resist layer 20 is preferably 20 nm to 10 µm, more preferably 100 nm to 1.2 µm. When the film thickness is more than 10 µm, a uniform resist film thickness is hardly attainable, and when the film thickness is less than 20 nm, uniform spin-coating is difficult.

### 1-2. Irradiation Step

After baking, an electron beam is irradiated. The preferable acceleration voltage of an electron beam varies depending on the type of the resist and the film thickness of the resist layer, but is preferably in the range of from 1 to 100 kV, more preferably from 1 to 10 kV, and still more preferably from 1 to 8 kV. The preferable dose amount also varies depending on the type of the resist and the film thickness of the resist layer, however is preferably in the range of from 1 µC/cm² to 50,000 µC/cm², more preferably from 5 µC/cm² to 10,000 µC/cm², and still more preferably from 10 µC/cm² to 1,000 µC/cm².
When the material of the resist and the film thickness of the resist layer are to be changed, it is preferable to change the acceleration voltage and dose amount appropriately.

The electron beam diameter is preferably 10 nm or less, and more preferably 3 nm or less. The lower limit of the beam diameter is not especially limited as long as the beam diameter may be narrowed down.

The line width may also be finely formed to 100 nm or less, further to 80 nm or less, by regulating the electron beam diameter and even to about 10 nm depending on the regulation. The electron beam diameter may be focused to about 3 nm, and may process the resist layer with a line width of nano order.

### 1-3. Development Step

After the irradiation with an electron beam, the resist layer is developed. This development is carried out using thermal desorption treatment.
By merely irradiating the resist layer with an electron beam, a depression may be formed on the irradiated portion; for example, a depression of about 50 nm in depth may be formed by selecting and regulating the type of the organopolysiloxane, the thickness of the resist, the acceleration voltage and the dose amount. In the present invention, therefore, the depression formed by an electron beam may be used as a mold pattern depending on the purpose, to omit the development step by thermal desorption.

However, when a depression of desired depth is to be formed with light exposure only, enormous light exposure is necessary and the exposure time is prolonged. In addition, the diameter of a depressed hole is increased as the light exposure is increased, thus making formation of a thin line and a small hole difficult.
Accordingly, the development with thermal desorption treatment according to the present invention is a method of developing the resist layer in patterns by heating the resist to eliminate the resist component in the irradiated portion such that the area of a hole formed by irradiation with an electron beam is enlarged and simultaneously the depth of the hole is increased, thereby achieving a reduction in the exposure time and formation of a shape of microscopic size.

The thermal desorption treatment is carried out preferably at a temperature not higher than the glass transition temperature of the polysiloxane. For example in the case of the organopolysiloxane whose methyl group content is from 5 to 25% by mass, the thermal desorption treatment is carried out preferably at 600°C or less, more preferably from 200°C to 600°C, and still more preferably from 300°C to 600°C.
In the treatment at a temperature higher than 600°C, there occurs a film reduction in the resist layer as a whole, resulting in a reduction in processed depth. In the treatment at a temperature lower than 200°C, the processed depth is the same as in mere irradiation with an electron beam, so the processed depth may not be increased and the advantage of thermal desorption treatment may not be evident.
The heating time in thermal desorption treatment varies depending on the material and thickness of the resist layer and a heating unit, and in the case of heating with a furnace, the heating time is generally preferably from 10 minutes to 2 hours, and more preferably from 30 minutes to 1 hour.

In heating, a furnace, lamp annealing, a hot plate, laser heating or the like may be used. Heating by lamp annealing is a method of increasing the temperature locally by irradiation with light. By excimer laser irradiation, energy corresponding to heat energy may be given by light, and in this case, an increase in temperature is reduced. In these cases, development may be carried out during drawing in a chamber of an electron beam drawing instrument.

The atmosphere in heating is not particularly limited, and heating may be conducted even in an air atmosphere. Heating may also be conducted in a nitrogen atmosphere, in an oxygen atmosphere, in a hydrogen atmosphere or the like. When heating is conducted under vacuum, the etching, with oxidization, of a substrate easily reacting with oxygen may be prevented, so a substrate made of a material such as carbide, having a resist layer, may be prevented. Accordingly, a substrate of diamond or the like may be usable.

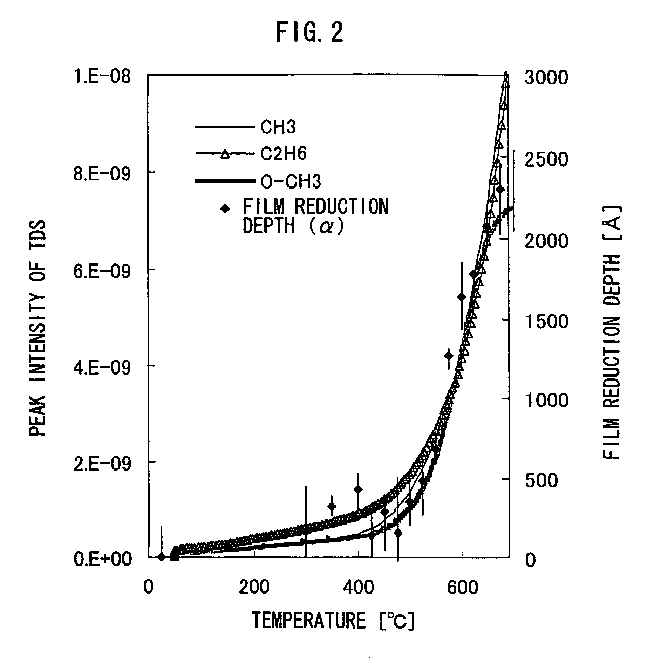

Now, the mechanism of development by thermal desorption treatment is examined.
When thermal desorption treatment is conducted, the resist layer is reduced as a whole to reduce film thickness. Accordingly, components sublimated upon film reduction by thermal desorption treatment without irradiation with an electron beam were analyzed by TDS (EMD-WA 1000S (ESCO Ltd.)). As a result, carbon components were detected as shown in Fig. 2. In Fig. 2, curves indicating CH₃, C₂H₆ and OCH₃ respectively show peak intensity obtained in TDS analysis on the left ordinate, and each plot indicative of film reduction shows depth [Å] on the right ordinate. In addition to the carbon components, water and hydrogen were also detected, but any other components were not detected.
In Fig. 2, plots indicative of film reduction in the resist layer are approximately consistent with the respective curves indicative of CH₃, C₂H₆ and OCH₃, and may be found to be approximately consistent with the amount of eliminated carbon components of organic groups in the organopolysiloxane.

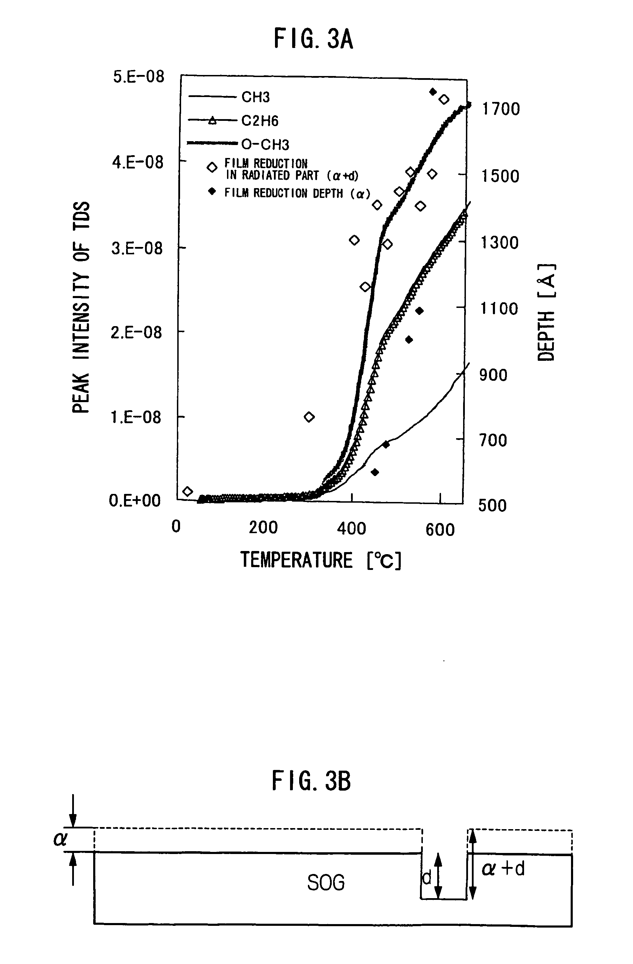

When a sample irradiated with an electron beam and then subjected to thermal desorption treatment was also analyzed similarly by TDS analysis, carbon components were detected as shown in Fig. 3 (A). In Fig. 3 (A), plots indicative of film reduction in the irradiated portion are also approximately consistent with a curve indicative of OCH₃ and may be found to be approximately consistent with the amount of the eliminated organic group in the organopolysiloxane. Film reduction, processed depth, and film reduction in the irradiated portion in Fig. 3 (A) are defined as shown in Fig. 3 (B). In Fig. 3 (B), α is film reduction, and d is processed depth. The sum of α and d, value (α + d) is film reduction in the irradiated portion.
When the eliminated amount of carbon components in the non-irradiated resist layer is compared with that in the irradiated resist layer in Fig. 3 (A), it may be seen that the eliminated amount in the non-irradiated resist layer is rapidly increased in the vicinity of 500°C, while the eliminated amount in the light-exposed resist layer is increased from 370°C. Similarly with respect to film reduction, the film reduction (α + d) in the irradiated portion is initiated at about 300°C, while the film reduction (α) in the non-irradiated portion is initiated at about 450°C. That is, it is estimated that a bond between a carbon atom and a silicon atom becomes easily cleavable in the irradiated portion.
Because film reduction is significantly increased in the vicinity of 500°C, processed depth seems to be reduced when the heating temperature is too high. The heating temperature is preferably in such a range that the film reduction by thermal desorption is not significant, and simultaneously thermal desorption in the irradiated portion proceeds, and preferably the heating temperature is selected appropriately depending on the type of the resist and the irradiation dose.

In the present invention, the resist on the irradiated portion, whether a positive resist or a negative resist, is removed by thermal desorption treatment.

In the process for producing a 3-dimension mold according to the present invention, development in the development step is carried out by thermal desorption treatment, thus making it unnecessary to consider the flow of a pattern by a developing solution, to enable formation of a fine pattern.
Because the organopolysiloxane is used as resist, a step of dry etching a metallic layer, a step of dry etching a substrate and a step of releasing a resist layer may be omitted and the process for manufacturing a 3-dimensional mold may be drastically simplified.
Depending on conditions such as the type of resist and the heating temperature in thermal desorption treatment, the strength of the resist layer may be increased, thus enabling production of a 3-dimensional mold excellent in handleability.

Processed depth may be attained by light exposure only, however when the exposure dose is increased to make the processed depth deeper, the diameter of a processed hole (or the width of a processed line) is made larger, and when the exposure is increased, the exposure time is increased resulting in a longer manufacturing time. On the other hand, when thermal desorption is carried out in addition to light exposure, processed depth may be made deeper even if the diameter of a processed hole (or the width of a processed line) is small.
Accordingly, the method of forming processed depth by light exposure only is useful as an easy method when a small processed-hole diameter (or processed-line width) is not required or a shallow processed depth is required; however, when a small processed-hole diameter (or processed-line width) is required or a deep processed depth is required, it is beneficial to conduct thermal desorption treatment in addition to light exposure.

### 2. 3-Dimensional mold

The 3-dimensional mold of the present invention is a 3-dimensional mold provided on a substrate with a resist layer having protrusion and depressions, which has a processed portion of 100 nm or less in line width. The 3-dimensional mold preferably has a processed portion of 100 nm or less in line width. Such 3-dimensional mold may be obtained by the production process described above. As a matter of course, a processed portion broader than that of 100 nm in line width may also be formed by the production process described above.
The line width may be finely formed to 100 nm or less, further to 80 nm or less, by regulating the electron beam diameter, and depending on the conditions of thermal desorption treatment, or even to about 10 nm depending on the regulation. In usual development methods, development is conducted with a developing solution, thus allowing a fine pattern to collapse or flow off in a drying step after development, but in the production process of the present invention, development is carried out without using a developing solution, so even a fine pattern may maintain its shape. As a result, a processed portion of fine line width which is conventionally hardly obtainable may be formed.

Diamond, silicon carbide, silicon, glass, sapphire, grassy carbon or silicon carbide may be used for a substrate.
Because diamond has superhigh hardness, a long lifetime is expected when imprinting is repeatedly performed. Further, because diamond has a low coefficient of thermal expansion, precise pattern transfer with a small dimensional change of the mold including the substrate may be expected in the case of imprinting having a heating step. Furthermore, because chemical resistance is high, cleaning may be performed even when the mold gets dirty, and various advantages may be expected such as minimum damage to the mold in the cleaning step.
When diamond is used as a substrate, the same fine processing is possible on any of natural diamond, bulk diamond by high-temperature high-pressure synthesis, or a diamond film by gas-phase synthesis. In the case of diamond by gas-phase synthesis, a diamond crystal oriented to a (111) or (100) surface is preferable in that uniform etching is possible. Further, the above-described diamond may be a semiconductor diamond doped with impurity elements. In the case of the semiconductor diamond, application to an electron device becomes possible. Application to tools and micro-machines is possible using the high wear resistance of the diamond.

Sapphire is a material with high strength although not to the extent of diamond. Further, because it transmits an ultraviolet light, it is the most suitable material in nano-imprinting having an optical curing step.

When silicon is used as a substrate, it may be any of amorphous silicon and single crystal silicon. In the case of single crystal silicon, the crystal surface is not especially limited. However, it is preferable to have a (110) surface. This also applies to a silicon oxide layer and a nitride layer. With this kind of crystal surface given, etching by an ion beam is favorable in the production method for a microfabrication product described later.

Glass is preferably quartz glass in view of properties such as heat resistance and transmissivity of ultraviolet rays. Glass, similar to sapphire, is the most suitable material for nano-imprinting having an optical curing step when an ultraviolet light is transmitted.

Glassy carbon is a material having a property of high heat resistance and is thus preferable for use in glass transfer requiring high temperature (300°C or more).

Silicon carbide is superior to silicon in high voltage resistance, high heat resistance, and radiation resistance.

The 3-dimensional mold in the present invention made by providing the resist layer having an uneven portion on a substrate may be used in an optical device or the like, and examples include a Fresnel zone plate, a diffraction grating, a binary optical device, a holographic optical device, a reflection prevention film, and media such as CDs and DVDs.
Further, the 3-dimensional mold may be used as a mold for molding of a micropattern molding.

### 3. Process for Producing a Microfabrication Product

The process for producing a microfabrication product in the present invention has a step of forming an uneven portion on the above-described substrate ((4) of Fig. 1) by irradiating an ion beam to a 3-dimensional mold made by providing a resist layer having an uneven portion on the substrate, obtained by the above-described process for producing the 3-dimensional mold.

Because the primary component of organopolysiloxane is constituted with silicon oxide, the processing speed is low for dry etching using an oxygen ion beam. On the other hand, the primary component of materials such as diamond or plastic used for a substrate is a carbon or hydrocarbon component, and the processing speed is high for oxygen ion beam etching. By utilizing this characteristic, in a case where organopolysiloxane is used as a mask for the oxygen ion beam, a 3-D pattern may be dug into the substrate when processing is curried out until the organopolysiloxane is all gone due to ion beam etching.

An oxygen ion beam, an argon ion beam, CF₄, CHF₃, SF₆, Cl₂, and the like may be used as the ion beam.

In irradiation with an oxygen ion beam, an acceleration voltage of from 50 to 3000 V is preferable, and from 100 to 1500 V is preferable. Microwave power is preferably from 50 to 500 W, and more preferably 100 to 200 W. The flow amount of oxygen gas is preferably from 1 to 10 sccm, and more preferably from 2 to 5 sccm. The ion current density is preferably 0.5 mA/cm² or more, and more preferably 1 mA/cm² or more.

An argon ion beam is preferably used when the substrate is quartz.

The processed depth of the substrate may be changed by changing the acceleration voltage and the dose amount of the ion beam.

### 4. Microfabrication Product

The microfabrication product in the present invention has a processed portion with a line width of 100 nm or less, according to the above-described process. Furthermore, it preferably has a processed portion with a line width of 10 nm or less. As a matter of course, the microfabrication product in the present invention may also have a processed portion broader than that of 100 nm in line width, according to the above-described production method.

The materials of the microfabrication product are those described in the substrate of the 3-dimensional mold described above, and diamond, silicon carbide, silicon, glass, sapphire, a resin, or the like may be used.
This microfabrication product may be used as a mold for molding a micropattern molding that is explained next.

### 5. Process for Producing a Micropattern molding

In the process for producing a micropattern molding in the present invention, the above-described 3-dimensional mold or the above-described microfabrication product is used as a mold for molding. When a resin is to be pressed against the microfabrication product, the resin is softened by setting the temperature higher than the glass transition temperature of the resin, then a mold is pressed against the resin, the resin is cured, and then the mold and the resin are peeled apart.

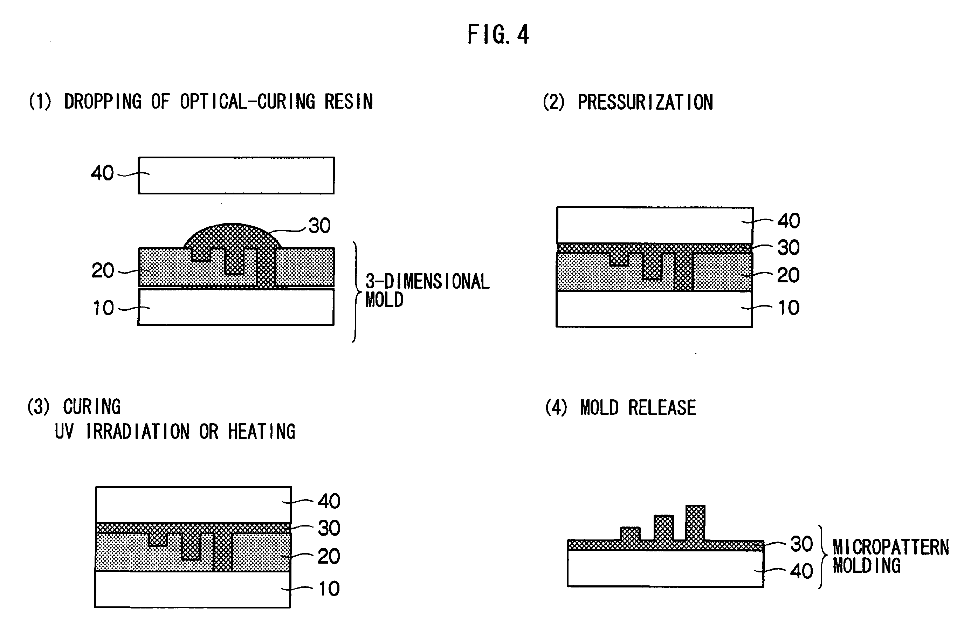

The production step of the micropattern molding is shown in Fig. 4.
A resin 30 is sandwiched between a glass 40 and the mold (Fig. 4(1)), and the resin 30 is cured (Fig. 4 (3)) while the pressure is kept constant (Fig. 4 (2)). After that, when the mold is separated, a micropattern molding of the resin 30 is formed on the glass 40 (Fig. 4 (4)). In Fig. 4, a 3-dimensional mold made by providing a resist layer having an uneven portion on a substrate is used as a mold. However, a microfabrication product made by forming unevenness on the substrate as described above may be used.

In the process for producing a micropattern molding in the present invention, it is desirable that peeling apart of the mold and resin is favorable. When the mold is formed from an organic substance such as a resin, the peeling off of the mold becomes difficult. Therefore, a 3-dimensional mold formed using organopolysiloxane of the present invention is preferably used as a mold to achieve excellent release from the resin.
Further, a peeling agent is preferably applied on the surface of the mold so that the mold is easily peeled off. An example of the peeling agent is a silane-coupling agent, and a metal thin film is also preferably provided to facilitate peeling. However, because the peeling agent is also peeled off when imprinting is repeatedly performed, it is preferable if it may be performed without the peeling treatment if possible. Moreover, when a microfabrication product using sapphire for a substrate is used as a mold, the peelability is excellent.

Either of a thermoplastic resin or an optical setting resin may be used for a resin to produce a micropattern molding.
Examples of the thermoplastic resin include an acrylic resin such as PMMA, polycarbonate, polyimide, and the acrylic resin such as PMMA is preferable.
The optical setting resin is preferably a resin cured with ultraviolet rays, or the like, and examples include an acrylic resin, an epoxy-based resin, a urethane-based resin, and mixtures thereof.

When the optical setting resin is used, the substrate or the mold must be able to transmit light such as ultraviolet rays. On the other hand, when a thermoplastic resin is used, a heating step becomes necessary and the mold is also deteriorated by heat. Therefore, it is preferable to use a resin with heat resistance.

In the case of a 3-dimensional mold and a microfabrication product using a plastic as a substrate, imprinting to a curved surface is also possible because the mold is soft. Further, because plastic is not expensive, it is also suitable for use in a disposal biochip, or the like.

### 6. Micropattern molding

The micropattern molding in the present invention has a processed portion with a line width of 100 nm or less. Preferably, it has a processed portion with a line width of 10 nm or less. As a matter of course, a processed portion with a line width of more than 100 nm may be formed by the production process described above.
The obtained micropattern molding and 3-dimensional mold may be used in an optical device by virtue of its shape and material. Examples include a Fresnel zone plate, a diffraction grating, a binary optical device, a holographic optical device, a reflection prevention film, and media such as CDs and DVDs.

Hereinafter, the present invention is specifically described by reference to the Examples. However, the present invention is not limited by these examples. Examples

### Example 1

### <Formation of a resist layer>

Sample 1 was manufactured by spin-coating a 10 mm² silicon substrate at 3000 rpm for 10 seconds with Accuglass 512B (manufactured by Honeywell) containing 14.7% by mass methyl silsesquioxane (organic group content: 14% by mass) in a mixed solvent of isopropyl alcohol, acetone, ethanol and butanol as a coating solvent, and then curing the resulting coating at 300°C for 1 hour. When the film thickness of Sample 1 was measured, it was about 500 nm.

### <Irradiation of an electron beam>

The sample obtained above was irradiated with an electron beam. In the electron beam irradiation, a scanning electron microscope ESA-2000 (manufactured by Elionix CO., LTD.) converted so that a pattern drawn on a personal computer could be exposed, was used.
Sample 1 was irradiated with an electron beam wherein the acceleration voltage was fixed to 10 kV, the dose amount to 500 µC/cm², the beam current to 1 nA, and the beam diameter to 100 nm.

### <Development by thermal desorption treatment>

The sample was developed by thermal desorption treatment under heating at 525°C for 30 minutes in an air atmosphere in a muffle furnace F0100 manufactured by Yamato Scientific Co., Ltd. Thereafter, the sample was cooled to room temperature over 60 minutes.

### <Results>

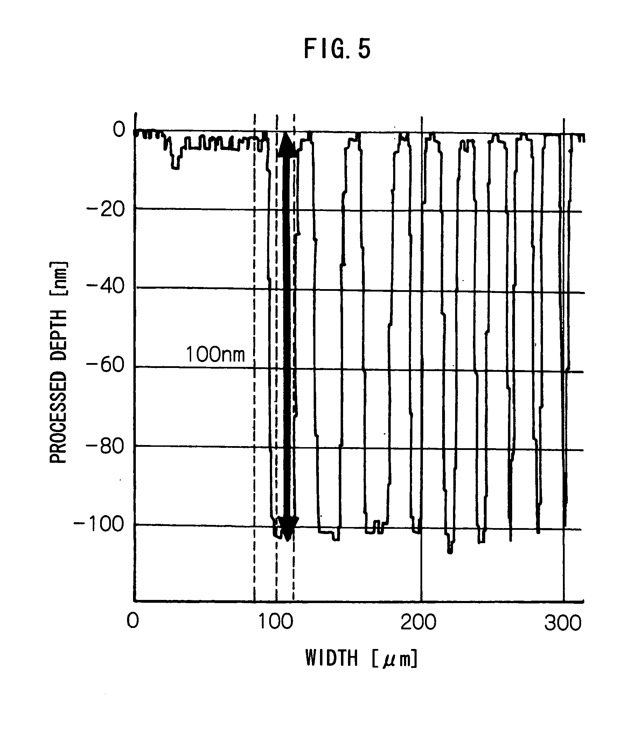

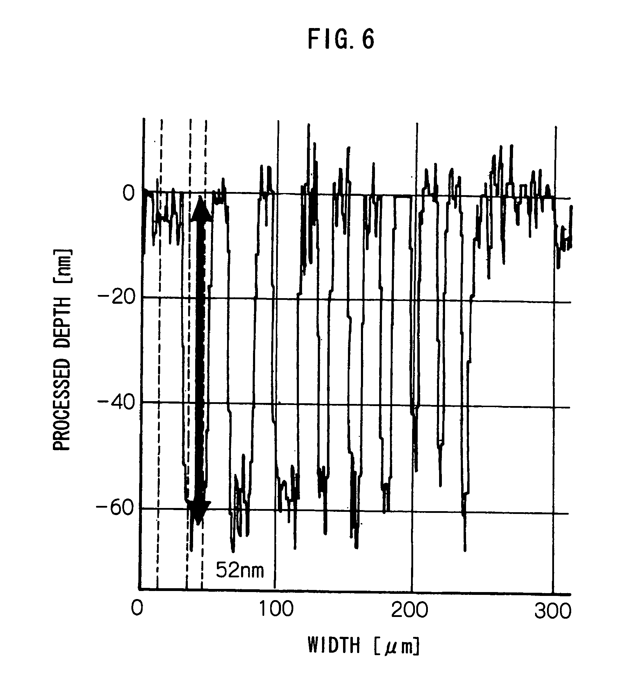

The processed depth of unevenness thus formed was measured using a step measurement machine (trade name: TENCOR ALPHA-STEP 500; manufactured by KLA-Tencor Co.).
The pattern of the resulting sample is shown in Fig. 5. As shown in Fig. 5, a pattern having a processed depth of 100 nm was obtained. A hole formed with electron beam exposure only is shown in Fig. 6. By light exposure only without thermal desorption treatment, an about 60-nm hole was formed.

### Example 2

Sample 1 produced in Example 1 was irradiated with an electron beam wherein the acceleration voltage was 10 kV and the dose amount was 400 µC/cm². The beam current was 1 nA, and the beam diameter was 100 nm. After electron beam irradiation, the sample was developed under conditions where the temperature was raised at a rate of 60°C/min. to 1000°C. Thereafter, the sample was cooled to room temperature, and the pattern of the resulting sample, as measured by the same method as in Example 1, had been processed to a depth of 30 nm.

### Example 3

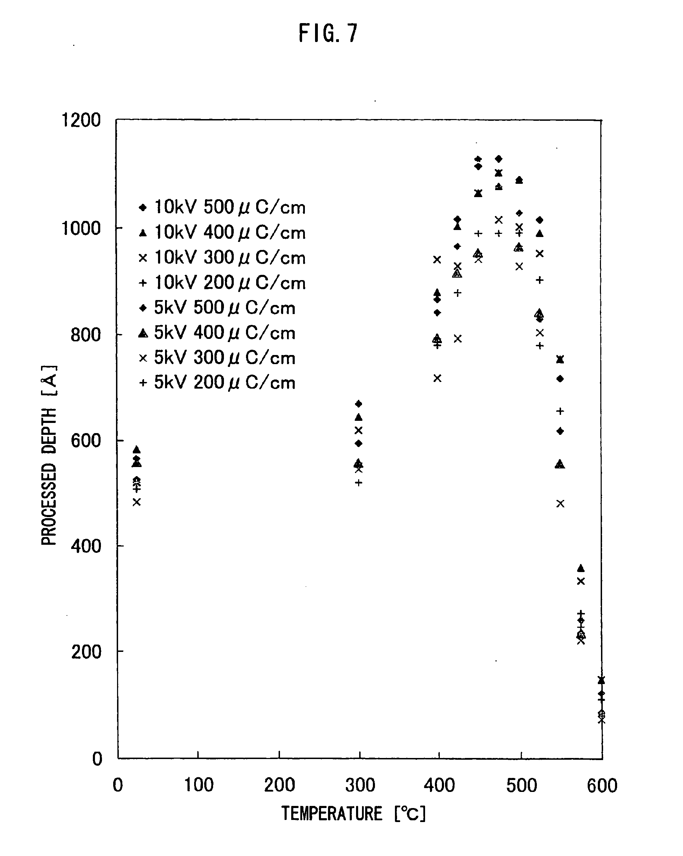

Sample produced in Example 1 was irradiated with an electron beam wherein the acceleration voltage was 5 or 10 kV and the dose amount was changed between 200 and 500 µC/cm². The beam current was 1 nA, and the beam diameter was 100 nm. After electron beam irradiation, the heating temperature at the time of thermal desorption was changed between 300°C and 600°C.
The relationship between the processed depth of the resulting 3-dimensional mold and the heating temperature at the time of thermal desorption is shown in Fig. 7.

As shown in Fig. 7, as the heating temperature at the time of thermal desorption is increased, the processed depth becomes deeper, but at a temperature higher than a peak temperature of 475°C, the processed depth becomes shallower. This is because the film reduction of the resist layer as a whole is made significant by thermal desorption, thus making the processed depth shallow.
At the heating temperature of 475°C at which the processed depth was deepest, the processed depth was about 110 nm where the acceleration voltage was 10 kV.
It was found that as the acceleration voltage is increased and the dose amount is increased, the processed depth is made deeper.

### Example 4

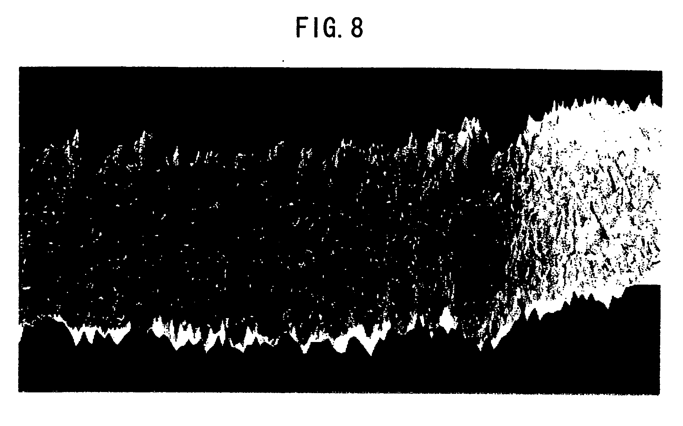

Sample 1 produced in Example 1 was irradiated with an electron beam. A scanning electron microscope ERA-8800FE (manufactured by Elionix CO., LTD.) converted so that a pattern drawn on a personal computer could be exposed, was used in the electron beam irradiation.
The sample was irradiated with an electron beam wherein the acceleration voltage was 10 kV and the dose amount was 800 µC/cm². The beam current was 80 pA. The beam diameter was 3 nm. A drawing pattern wherein lines each having a line width of 20 nm were arranged at intervals of 20 nm was used. After electron beam irradiation, the sample was developed by thermal desorption treatment at 475°C for 30 minutes.
An AFM image of the resulting 3-dimensional mold is shown in Fig. 8. As shown in Fig. 8, 20-nm L&S (line & space) had been formed. The processed depth could not be measured because a needle of AFM did not reach the bottom, so the processed depth was confirmed in a broader pattern of L&S of the same sample, indicating a processed depth of 110 nm, and the processed depth was estimated to be similar, also in the 20-nm L&S, to this processed depth.

### Example 5

### <Production of a microfabrication product>

Sample 5 was produced in the same manner as in Example 1 except that the heating temperature at the time of thermal desorption was changed to 475°C. The film thickness of Sample 5 was 500 nm.
The resulting Sample 5 was irradiated with an electron beam in the same manner as in Example 1.

The silicon substrate of the 3-dimensional mold obtained by electron beam irradiation was etched via the resist layer of the 3-dimensional mold as a mask with an oxygen ion beam. The etching was performed until the polysiloxane mask (resist layer) disappeared under the ion beam etching conditions where the acceleration voltage was 300 V, the microwave power was 100 W, the oxygen gas flow was 3 sccm, the ion beam current density was 0.48 mA/cm², and the process time was 90 minutes.
When the profile of the silicon substrate after etching was measured using a step measurement machine (trade name: Tencor Alpha-Step 500; manufactured by KLA-Tencor Co.), it was found that a microfabrication product of silicone corresponding to a 3-D step structure of the polysiloxane layer (resist layer) was obtained.

### Example 6

### <Production of a micropattern molding>

Sample 6 was produced in the same manner as in Example 1 except that the heating temperature at the time of thermal desorption was changed to 475°C. The film thickness of Sample 6 was 500 nm.
A micropattern molding was produced using Sample 6 having protrusions and depressions in a resist layer, as a mold for molding. PAK-01 (manufactured by Toyo Gosei Co., Ltd.) was used for an optical setting resin, the imprint pressure was set to 0.5 MPa, and the irradiation dose of ultraviolet rays was 1 J/cm².
As a result, it was found that the pattern was transferred faithfully corresponding to the pattern of the resist layer of Sample 6.

### Example 7

### <Production of a micropattern molding>

A micropattern molding was produced using Sample 5 (microfabrication product of silicon) prepared in Example 5, as a mold for molding. PAK-01 (manufactured by Toyo Gosei Co., Ltd.) was used for an optical setting resin, the imprint pressure was set to 0.5 MPa, and the irradiation dose of ultraviolet rays was 1 J/cm².
As a result, it was found that the pattern was transferred faithfully corresponding to the pattern of the microfabrication product of Sample 5.

### Example 8

### <Formation of a resist layer>

Sample 8 was manufactured by spin-coating a 10-mm² silicon substrate with Accuglass 312B (manufactured by Honeywell) containing 10.0% by mass methyl silsesquioxane (organic group content: 15% by mass) in a mixed solvent of isopropyl alcohol, acetone, ethanol and butanol as a coating solvent, at 300 rpm for 3 seconds for pre-spinning and at 3000 rpm for 10 seconds for main spinning and then curing it at 300°C for 1 hour. When the film thickness of Sample 8 was measured, it was about 300 nm.

### <Irradiation with an electron beam>

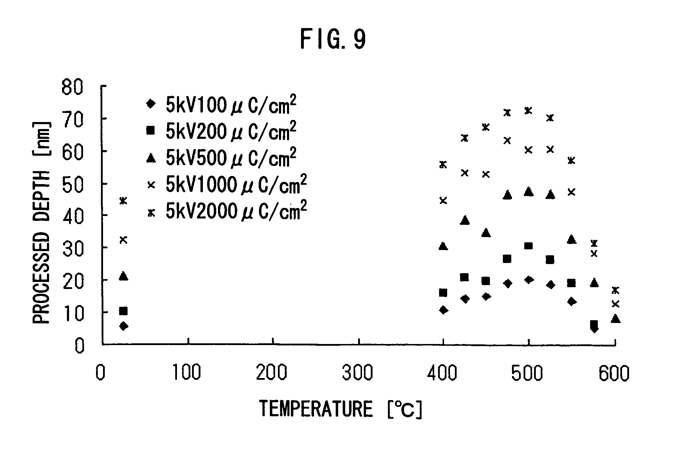

Sample 8 was irradiated with an electron beam in the same manner as in Example 1 except that the acceleration voltage was 5 kV, and the dose amount was changed to 100, 200, 500, 1000 or 2000 µC/cm². The beam current was 1 nA. The beam diameter was 100 nm. After electron beam irradiation, the heating temperature at the time of thermal desorption was changed between 400°C and 600°C.
The relationship between the processed depth of the resulting 3-dimensional mold and the heating temperature at the time of thermal desorption is shown in Fig. 9.

Fig. 9 shows that as the heating temperature at the time of thermal desorption is increased, the processed depth becomes deeper, but at a temperature higher than 500°C at which the processed depth is peaked, the processed depth becomes shallower. This is because the film reduction of the resist layer as a whole is made significant by thermal desorption, thus making the processed depth shallow.
At the heating temperature of 500°C at which the processed depth was deepest, the processed depth was about 70 nm where 2000 µC/cm² was irradiated.

### Example 9

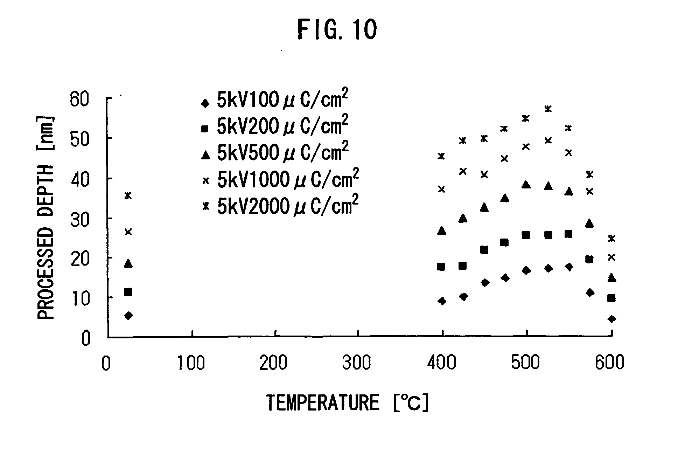

Sample 9 was produced in the same manner as in Example 8 except that Accuglass 311 (manufactured by Honeywell) containing 10.5% by mass methyl silsesquioxane with an organic-group content of 10% by mass in a mixed solvent of isopropyl alcohol, acetone, ethanol and butanol as a coating solvent was used in place of Accuglass 312B. Sample 9 was irradiated with an electron beam in the same manner as in Example 8 to produce a 3-dimensional mold. After electron beam irradiation, the sample was developed by thermal desorption treatment under heating at 525°C for 30 minutes in an air atmosphere in a muffle furnace F0100 manufactured by Yamato Scientific Co., Ltd. Thereafter, the sample was cooled to room temperature over 60 minutes. The relationship between the processed depth of the resulting 3-dimensional mold and the heating temperature at the time of thermal desorption is shown in Fig. 10.

Fig. 10 shows that as the heating temperature at the time of thermal desorption is increased, the processed depth becomes deeper, but at a temperature higher than 525°C at which the processed depth is peaked, the processed depth becomes shallower. This is because the film reduction of the resist layer as a whole is made significant by thermal desorption, thus making the processed depth shallow.
At the heating temperature of 525°C at which the processed depth was deepest, the processed depth was about 55 nm where 2000 µC/cm² was irradiated.

### Example 10

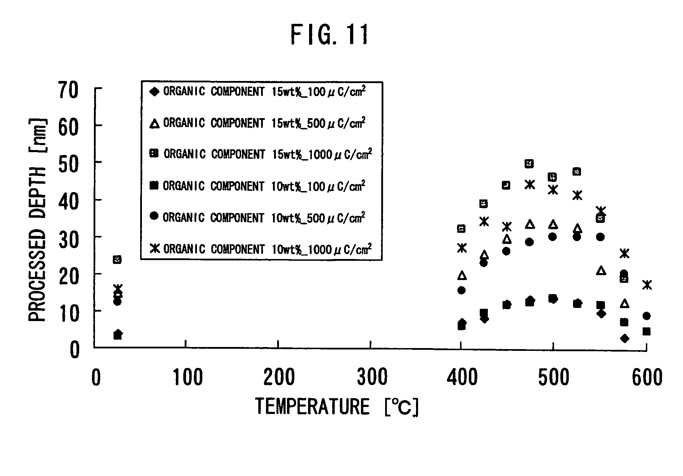

A 3-dimensional mold was produced in the same manner as in Examples 8 and 9 except that the acceleration voltage of 5 kV was changed to 10 kV.
The relationship between the processed depth of the resulting 3-dimensional mold and the heating temperature at the time of thermal desorption is shown in Fig. 11.

### Example 11

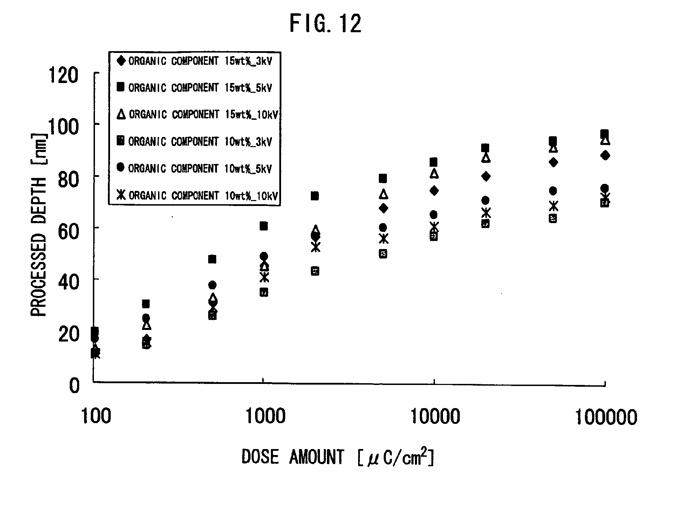

A 3-dimensional mold was produced in the same manner as in Example 8 except that the acceleration voltage of 5 kV was changed to 3, 5 or 10 kV, the temperature in thermal desorption treatment was fixed to 500°C in place of the temperature changed between 400°C and 600°C, and the dose amount was changed to 100 to 100,000 µC/cm².
A 3-dimensional mold was produced in the same manner as in Example 9 except that the acceleration voltage of 5 kV was changed to 3, 5 or 10 kV, the temperature in thermal desorption treatment was fixed to 525°C in place of the temperature changed between 400°C and 600°C, and the dose amount was changed to 100 to 100,000 µC/cm².
The relationship between the processed depth of the resulting 3-dimensional mold and the dose amount is shown in Fig. 12.

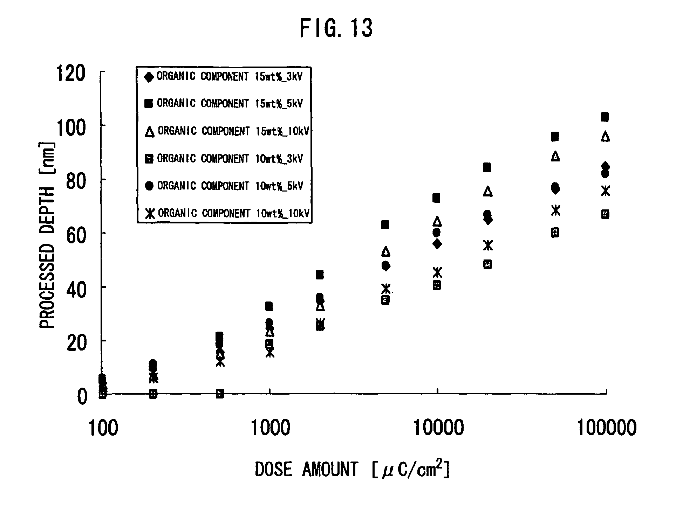

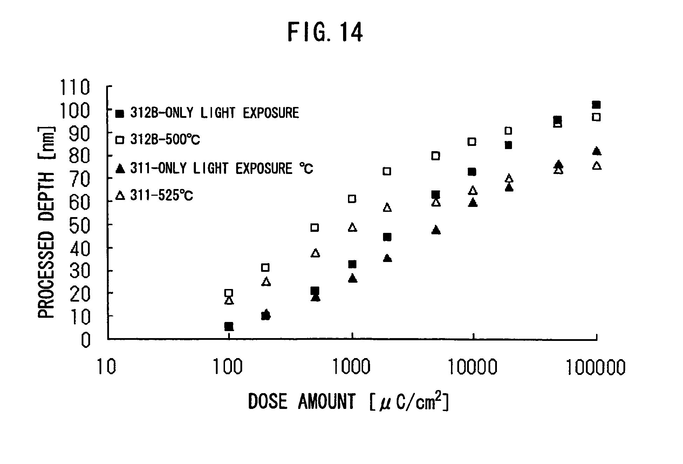

As shown in Fig. 12, it may be seen that with any carbon contents given, the processed depth is increased as the dose amount is increased.
The relationship between the processed depth formed by light exposure only without thermal desorption treatment and the dose amount is shown in Fig. 13. As shown in Fig. 13, the processed depth is made deep even by light exposure only.
The relationship between the processed depth formed by light exposure only and the processed depth formed by performing thermal desorption treatment is shown in Fig. 14 where the acceleration voltage was 5 kV, and the temperature in thermal desorption treatment was 500°C for Accuglass 312B or 525°C for Accuglass 311.
When the dose amount was 100,000 µC/cm², the processed depth formed by light exposure only was deeper than the processed depth formed by performing thermal desorption treatment, as shown in Fig. 14. An estimated reason for this is that by thermal desorption treatment, the film thickness of the resist layer as a whole was reduced and the phenomenon of film reduction occurred.

### Example 12

Sample 9 produced in Example 9 was irradiated with an electron beam in the same manner as in Example 1 except that the acceleration voltage was 5 kV, and the dose amount was 500,1000 or 2000 µC/cm². The beam current was 1 nA and the beam diameter was 100 nm. After electron beam irradiation, the sample was developed by thermal desorption treatment in the same manner as in Example 9.

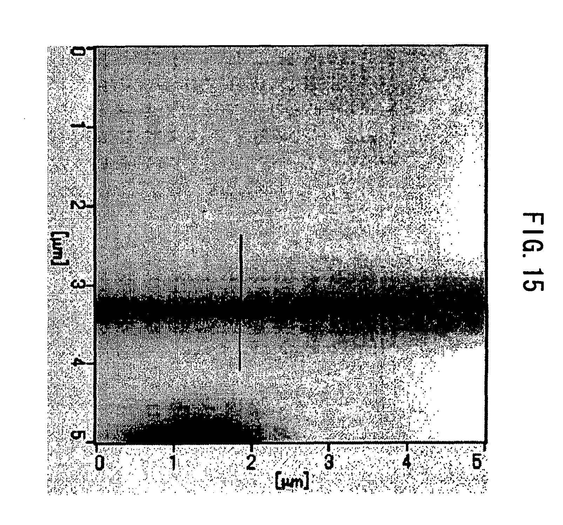

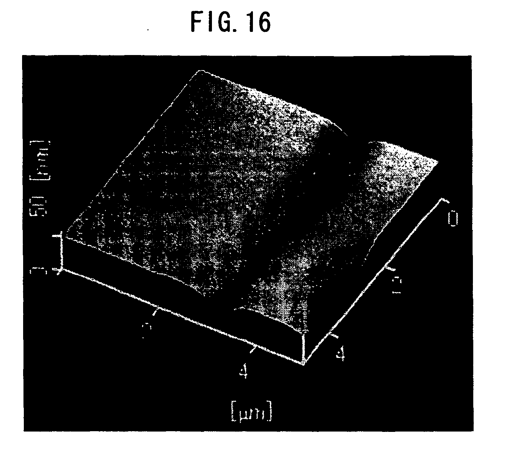

A line of the designed size of 100 nm, formed on the resulting 3-dimensional mold, was measured for its change in line width with AFM (Atomic Force Microscope). The measurement region was 5 µm × 5 µm, and this region was measured with 512 scanning lines.
From measurement results after image processing with AFM (see, for example, Fig. 15), the width of a portion different in color tone was measured, and this width was assumed to be the line width. The line width used herein is estimated to correspond to half-width relative to the change in the depth of a pattern. For the purpose of confirming a change in line width, a relative value of change in line width may be confirmed in this example by the method of measuring line width by AFM. Some measurement results after image processing are shown in Figs. 15 and 16. Figs. 15 and 16 show the profile of a line formed with an acceleration voltage of 5 kV and a dose amount of 2000 µC/cm² and subjected to image processing with AFM, and Fig. 15 shows the state of a line-shaped pattern observed from the above, and Fig. 16 shows the state of the line-shaped pattern observed obliquely.

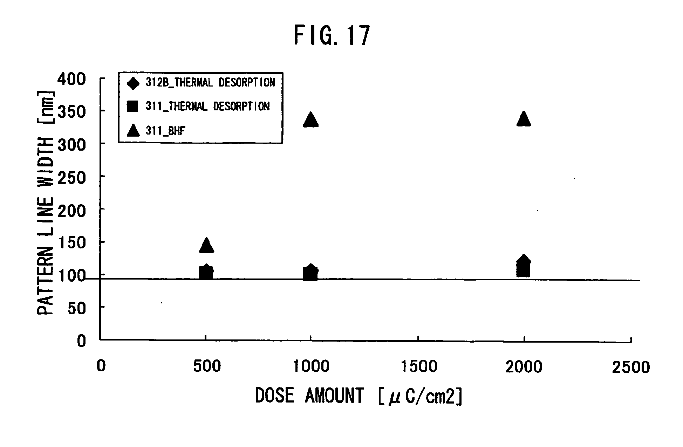

The relationship between the measured line width and the dose amount is shown in Fig. 17. As shown in Fig. 17, the line width is not made broad even if the dose amount is increased, and the designed size of 100 nm may be maintained.

### Example 13

A 3-dimensional mold was produced in the same manner as in Example 12 except that Accuglass 312B was used in place of Accuglass 311, and thermal desorption treatment was carried out at 500°C.
The relationship between the line width measured in the same manner as in Example 12 and the dose amount is shown in Fig. 17. As shown in Fig. 17, the line width is not made broad even if the dose amount is increased, and the designed size of 100 nm may be maintained. It was found that line width is made easily broad when Accuglass 312B with a higher content of organic components (carbon components) is used.

### Comparative Example 1

A 3-dimensional mold was formed in the same manner as in Example 12 except that although thermal development treatment was used to form a pattern in Example 12, development was carried out by dipping in a hydrofluoric acid buffer (BHF) (HF : NH₄F = 1 : 1 mixture) for 90 seconds and subsequent rinsing with purified water.
The relationship between the line width measured in the same manner as in Example 12 and the dose amount is shown in Fig. 17. As shown in Fig. 17, it was revealed that the line width is made broader in the liquid development with a hydrofluoric acid buffer than in the thermal development treatment.

### Example 4

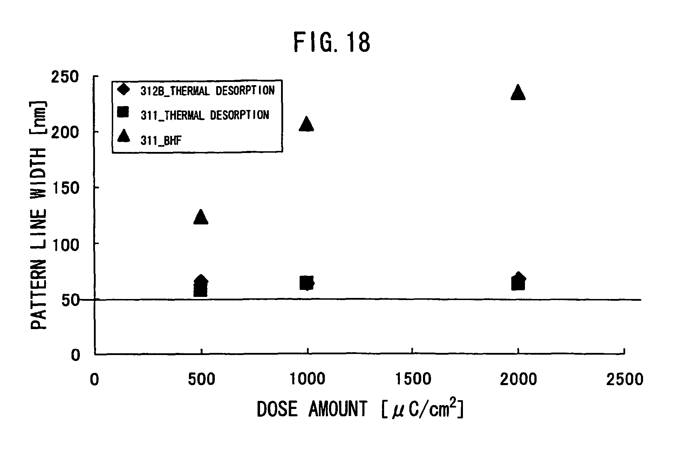

A 3-dimensional mold was formed in the same manner as in Examples 12 and 13 except that a pattern was formed with the designed size of 50 nm in place of the designed size of 100 nm.
The relationship between the line width measured in the same manner as in Example 12 and the dose amount is shown in Fig. 18. Although the obtained line width was about 60 nm relative to the designed size of 50 nm, a pattern having a size near to the objective size could be obtained. Even if the dose amount was increased, the line width showed a constant value.

### Comparative Example 2

A 3-dimensional mold was formed in the same manner as in Example 12 except that although a pattern with the designed size of 100 nm was formed by thermal development treatment in Example 12, a pattern with the designed size of 50 nm was formed by development consisting of dipping in a hydrofluoric acid buffer (HF : NH₄F = 1 : 1 mixture) for 90 seconds and subsequent rinsing with purified water.
The relationship between the line width measured in the same manner as in Example 12 and the dose amount is shown in Fig. 17. As shown in Fig. 17, it was revealed that the line width is made broader in the liquid development with a hydrofluoric acid buffer than in the thermal development treatment.

### Description of the Reference Numerals

10 : Substrate
20 : Resist layer
30 : Resin
40: Glass

## Claims

1. A process for producing a 3-dimensional mold, comprising:
irradiating a resist layer of a processing object having the resist layer made of an organopolysiloxane on a substrate with an electron beam, and
developing the resist layer after the irradiation with an electron beam to form protrusions and depressions in the resist layer,
wherein the development is development by thermal desorption treatment.

2. The process for producing a 3-dimensional mold according to claim 1, wherein the organic group in the organopolysiloxane is a methyl group or a phenyl group.

3. The process for producing a 3-dimensional mold according to claim 1, wherein the organic group in the organopolysiloxane is a methyl group.

4. The process for producing a 3-dimensional mold according to any one of claims 1 to 3, wherein the heating temperature in the thermal desorption treatment is not more than the glass transition temperature of the organopolysiloxane.

5. The process for producing a 3-dimensional mold according to claim 4, wherein the heating temperature in the thermal desorption treatment is 600°C or less when the organic group in the organopolysiloxane is a methyl group and simultaneously the content of the organic group in the organopolysiloxane is 5 to 25% by mass.

6. A 3-dimensional mold of 100 nm or less in line width produced by the process according to any one of claims 1 to 5.

7. A process for producing a microfabrication product comprising a substrate having protrusions and depressions, the process comprising irradiating with an ion beam a resist layer of a 3-dimensional mold produced by the process for producing a 3-dimensional mold, in which a resist layer having protrusions and depressions is provided on a substrate, according to any one of claims 1 to 5, whereby protrusions and depressions are formed on the substrate.

8. A microfabrication product having a processed portion of 100 nm or less in line width produced by the process according to claim 7.

9. The microfabrication product according to claim 8, which comprises diamond, silicon, glass, sapphire, glassy carbon, or silicon carbide.

10. A process for producing a micropattern molding, comprising:
transferring a pattern through molding to a resin by pressing the resin against a 3-dimensional mold produced by the process according to any one of claims 1 to 5, and
releasing the pressed resin from the 3-dimensional mold.

11. A process for producing a micropattern molding, comprising:
transferring a pattern through molding to a resin by pressing the resin against a microfabrication product produced by the process according to claim 7, which is used as a mold, and
releasing the pressed resin from the microfabrication product.

12. A micropattem molding having a processed portion of 100 nm or less in line width produced by the process according to claim 10 or 11.

13. An optical device having a 3-dimensional mold produced by the process of any one of claims 1 to 5.

14. An optical device having a microfabrication product produced by the process of claim 7.

15. An optical device having a micropattern molding produced by the process of claim 10 or 11.
